# EUROPÄISCHE PATENTSCHRIFT

(11) **EP 2 798 679 B1**
(45) Veröffentlichungstag und Bekanntmachung des Hinweises auf die Patenterteilung: **10.01.2018**
(21) Anmeldenummer: 12812610.9
(22) Anmeldetag: 19.12.2012
(51) Int. Cl.: H01L 41/083, H01L 41/053, H01L 41/338, H01L 41/23

(54) **PIEZOSTACK MIT PASSIVIERUNG UND VERFAHREN ZUR PASSIVIERUNG EINES PIEZOSTACKS**
PIEZO-STACK WITH PASSIVATION, AND A METHOD FOR THE PASSIVATION OF A PIEZO-STACK
PILE PIÉZO-ÉLECTRIQUE AVEC PASSIVATION ET PROCÉDÉ DE PASSIVATION D'UNE PILE PIÉZO-ÉLECTRIQUE

(30) Priorität: 30.12.2011 DE 102011090156
(43) Veröffentlichungstag der Anmeldung: 05.11.2014
(73) Patentinhaber: Continental Automotive GmbH, 30165 Hannover (DE)
(72) Erfinder: RICHTER, Thomas, 93049 Regensburg (DE); KASTL, Harald Johannes, 95686 Fichtelberg (DE); ZUMSTRULL, Claus, 93128 Regenstauf (DE)
(86) Internationale Anmeldenummer: PCT/EP2012/076228
(87) Internationale Veröffentlichungsnummer: WO 2013/098168

(56) Entgegenhaltungen:
- WO-A1-2012/099233
- WO-A1-2013/017592
- WO-A2-02/089225
- DE-A1- 10 021 919
- US-A1- 2007 247 025

## Beschreibung

Die vorliegende Erfindung betrifft und ein Verfahren zur Passivierung eines Piezostacks sowie einen Piezostack, der mit einem solchen Verfahren hergestellt ist.

Piezoelektrische Bauteile können beispielsweise in Form von Piezoaktoren als Vielschichtbauelemente mit einer Anzahl von jeweils alternierend angeordneten piezoelektrischen Keramikschichten und Elektrodenschichten ausgebildet sein, und gewinnen in der modernen Elektrotechnik immer mehr an Bedeutung. Beispielsweise werden Piezoaktoren als Stellantriebe, in Verbindung mit Ventilen und dergleichen, eingesetzt. Piezoaktoren werden auch bei der Einspritzung von Kraftstoff in einen Brennraum verwendet. Hierbei steigen die Anforderungen entsprechend den gesteigerten Anforderungen hinsichtlich Emission und Verbrauch. Höhere Drücke und Temperaturen, sowie mehrfach-Einspritzungen erfordern eine höhere Temperaturbeständigkeit des Aktors sowie eine hohe Dauerhaltbarkeit.

Ein bekannter Piezoaktor ist beispielsweise in der DE 196 46 676 C1 beschrieben. Bei den verwendeten Piezokeramiken wird der Effekt ausgenutzt, dass diese sich unter einem mechanischen Druck, beziehungsweise Zug, aufladen und andererseits bei Anlegen einer elektrischen Spannung entlang der Hauptachse der Keramikschicht ausdehnen. Zur Vervielfachung der nutzbaren Längenausdehnung werden beispielsweise monolithische Vielschichtaktoren verwendet, die aus einem gesinterten Stapel dünner Folien aus Piezokeramik (beispielsweise Bleizirkonattitanat) mit eingelagerten metallischen Elektrodenschichten bestehen. Die Elektrodenschichten sind wechselseitig aus dem Stapel herausgeführt und über Außenmetallisierungen elektrisch parallel geschaltet. Auf den beiden Kontaktseiten des Stapels ist hierzu jeweils eine streifen- oder bandförmige, durchgehende Außenmetallisierung aufgebracht, die mit allen Elektrodenschichten gleicher Polarität verbunden ist.

Wird eine elektrische Spannung an die Außenkontaktierung angelegt, so dehnen sich die Piezofolien in Feldrichtung aus. Durch die mechanische Serienschaltung der einzelnen Piezofolien wird die Nenndehnung des gesamten Stapels schon bei relativ niedrigen elektrischen Spannungen erreicht.

Zur Erzielung einer optimalen Auslenkung des piezokeramischen Vielschichtaktors bei gleichzeitig minimalem Platzbedarf ist es günstig, wenn die Elektrodenschichten den gesamten Querschnitt des Aktors umfassen. Diese Art von Aktor ist auch unter dem Begriff vollaktiver Piezostack bekannt. Das bedeutet, dass Elektrodenschichten alternierender Polarität an den seitlichen Oberflächen der Vielschichtkeramik freiliegen.

Aus diesem Grund ist es erforderlich, diese freiliegenden Elektrodenschichten mit einer geeigneten Passivierung zu versehen. Bei einer Passivierung handelt es sich im allgemeinen um eine nicht-metallische Schutzschicht, Isolationsschicht oder dergleichen, mittels derer elektrische Überschläge und Kurzschlüsse zwischen benachbarten Elektrodenschichten vermieden werden können. Ohne eine Passivierung könnten solche Überschläge und Kurzschlüsse, beispielsweise durch mechanische Beschädigung der Oberfläche oder durch Kontaminierung mit Verunreinigungen (beispielsweise Schleifstaub, Fingerabdrücke und dergleichen), Feuchtigkeit oder Betriebsstoffen (beispielsweise Diesel, Rapsmethylester und dergleichen), hervorgerufen werden. Derartige Beschädigungen und/oder Kontaminierungen können insbesondere im Betrieb des Aktors, aber auch während des Herstellungsprozesses erfolgen.

Eine Möglichkeit dieser isolierenden Schicht ist das Auftragen einer Lackschicht, welche als Material ein Polyimid umfassen kann. Die Familie der Polyimide haben sich für diese Anwendung aufgrund ihrer Eigenschaften hinsichtlich Glastemperatur, Temperaturbeständigkeit und Isolationseigenschaften als am besten geeignet dargestellt. Allerdings kann es bei der Passivierung mit Polyimidlack während des Auftrag- und Aushärteprozesses zu Schichtdickeninhomogenitäten, und an den Kanten zu teilweise nicht ausreichender Bedeckung (Kantenflucht) kommen. In Folge können elektrische Spannungsüberschläge im Betrieb auftreten.

Ein gängiger Ansatz ist, eine allseitige Passivierung eines Piezostacks vorzunehmen, wobei jede der vier Seiten separat beschichtet und ausgehärtet wird. Piezostacks, bei denen schlecht bedeckte Kanten vorliegen, werden anschließend verworfen.

Die Passivierung von Piezostacks auf allen vier Seiten ist sehr aufwendig. Dieser Aufwand wird zusätzlich durch den Materialausschuss aufgrund von mängelbehafteten Piezostacks erhöht.

Aus der WO 2002/089225 ist bekannt, ein Passivierungsmaterial für ein piezoelektrisches Bauteil in Vielschichtbauweise bereitzustellen, das eine Reißfestigkeit aufweist, die kleiner ist als die Haftfestigkeit des Passivierungsmaterials auf dem elektrischen Bauteil. Dabei sind u.a. Kunststoffe, Polyurethane, Harze oder Polyimide vorgesehen. Aus der US 2007 024 7025 A1 ist zudem bekannt, als Passivierungsmaterial Glas zu verwenden.

Die Aufgabe der vorliegenden Erfindung besteht darin, ein Verfahren zur Herstellung eines Piezostacks mit einer verbesserten Passivierung anzugeben.

Diese Aufgabe wird erfindungsgemäß durch ein Verfahren gemäß Anspruch 1 gelöst.

Ein mit einem solchen Verfahren hergestellter Piezostack umfasst
- mehrere Seitenflächen,
- eine erste Passivierungsschicht, welche auf einer ersten Seitenfläche aufgebracht ist, und
- wobei die erste Passivierungsschicht im Querschnitt ein Rechteck ausbildet und mit den an die erste Seitenfläche des
- Piezostacks angrenzenden Seitenflächen des Piezostacks bündig abschließt.

Der Piezostack ist vorzugsweise ein vollaktiver Stack. Ein erfindungsgemäßer Piezostack ist vorzugsweise quaderförmig und wird begrenzt durch zwei zur Stapelrichtung (Achsrichtung) senkrechte, rechteckige Oberflächen sowie durch vier rechteckige Seitenflächen, welche sich parallel zur Achsrichtung erstrecken. Die Seitenflächen weisen jeweils eine Länge, bzw. Breite (senkrecht zur Achse) und eine Höhe (in Achsrichtung) auf.

Eine erste Seitenfläche des Piezostacks weist eine Passivierungsschicht auf, deren Querschnitt im Schnitt senkrecht zur Achse im Wesentlichen rechteckig ist. Dabei erstreckt sich die Passivierungsschicht vorteilhaft über die gesamte Länge bzw. Breite der ersten Seitenfläche mit einer einheitlichen Schichtdicke. Dies bedeutet, dass an den Rändern keine Kantenflucht auftritt. Vorzugsweise weist die Passivierungsschicht über die gesamte erste Seitenfläche hinweg eine einheitliche Schichtdicke auf. Somit ist die Oberfläche der Passivierungsschicht planparallel zu der ersten Seitenoberfläche des Piezostacks. Dadurch können im Randbereich des Piezeostacks elektrische Überschläge zwischen benachbarten Elektroden vermieden werden.

In einer vorteilhaften Ausgestaltung der Erfindung umfasst der Piezostack
- eine zweite Passivierungsschicht, welche auf einer zweiten Seitenfläche aufgebracht ist,
- wobei die zweite Seitenfläche gegenüberliegend zur ersten Seitenfläche angeordnet ist, und
- wobei die zweite Passivierungsschicht im Querschnitt ein Rechteck ausbildet und mit den an die zweite Seitenfläche des Piezostacks angrenzenden Seitenflächen des Piezostacks bündig abschließt.

Die zweite Passivierungsschicht kann wie die erste Passivierungsschicht ausgebildet sein und kann insbesondere alle oben für die erste Passivierungsschicht beschriebenen Merkmale aufweisen. Eine zweite Passivierungsschicht, die ebenfalls bündig mit den Seitenflächen des Piezostacks abschließt, hat den Vorteil dass der Piezostack von zwei gegenüberliegenden Seiten zuverlässig elektrisch kontaktiert werden kann. Die Möglichkeit der gegenüberliegenden Kontaktierung ist für das Anlegen einer gewünschten Spannung an sich auszudehnende Keramiken vorteilhaft.

Die Kontaktierung des Piezostacks erfolgt vorzugsweise über die erste und/oder zweite Passivierungsschicht. Für eine zuverlässige Kontaktierung der Innenelektroden des vorzugsweise vollaktiven Piezostacks wird die erste und/oder zweite Passivierungsschicht bespielsweise unter Ausbildung von Gräben strukturiert, so dass jede zweite Innenelektrode durch einen Graben freigelegt wird. In den Gräben kann dann eine Kontaktierung der freigelegten Innenelektroden mit einer Außenelektrode, z.B. mit einem Leitkleber erfolgen.

In einer vorteilhaften Ausgestaltung umfasst die erste und/oder zweite Passivierungsschicht Kunststoff. Kunststoff ist ein elektrisch isolierendes Material, das sicherstellt, dass es im Betrieb des Piezostacks zu keinen Spannungsüberschlägen zwischen benachbarten Elektroden kommt. Besonders bevorzugt weist die erste und/oder zweite Passivierungsschicht ein Polyimid auf. Dieses eignet sich besonders für eine Strukturierung zur Bildung der Gräben, z.B. mit Hilfe eines Lasers.

Gemäß einer bevorzugten Weiterbildung weist der Piezostack auch an den dritten und/oder vierten Seitenflächen eine dritte und/oder vierte Passivierungsschicht auf. Diese können aus demselben Material bestehen wie die erste und zweite Passivierungsschicht. Sie können aber auch ein anderes Material, beispielsweise Keramik, Glas oder ein temperaturbeständiges Silikon aufweisen.

Die dritte und/oder vierte Passivierungsschicht ist vorzugsweise nach der ersten und/oder zweiten Passivierungsschicht aufgetragen, so dass sie sich in ihrer Ausdehnung senkrecht zur Stapelrichtung des Piezostacks über den Piezostack hinaus auch über die Dicke der ersten und zweiten Passivierungsschichten erstrecken. Diese dritten und vierten Passivierungsschichten können zu ihren an die erste und zweite Passivierungsschicht angrenzenden Kanten hin jeweils eine Kantenflucht aufweisen, d.h. ihre Schichtdicken können zu diesen Kanten hin abnehmen ohne dass die Funktion des erfindungsgemäßen Piezostacks beeinträchtigt wird. Wenn sich die dritte und vierte Passivierungsschicht über den Piezostack hinaus auch über die Dicke der ersten und zweiten Passivierungsschicht erstreckt, ist die Schichtdicke über den Kanten des Piezostacks auch bei einer Kantenflucht ausreichend groß um Spannungsüberschläge und Kurzschlüsse zu verhindern.

Das erfindungsgemäße Verfahren zur Passivierung von wenigstens einer Seitenfläche mit einer ersten Länge eines Piezostacks, wobei die erste Länge durch mechanische Teilung eines Piezoriegels mit einer zweiten Länge entlang von zur zweiten Länge senkrecht verlaufenden Trennachsen entsteht, weist folgende Verfahrensschritte auf:
- Bereitstellung eines Piezoriegels mit Seitenflächen mit der zweiten Länge, wobei die zweite Länge (L2) größer ist als die erste Länge,
- Aufbringung einer ersten Passivierungsschicht auf wenigstens einer ersten Seitenfläche des Piezoriegels mit der zweiten Länge,
- Aushärtung der ersten Passivierungsschicht, und
- mechanische Teilung des Piezoriegels, so dass wenigstens ein Piezostack mit der ersten Länge erhalten wird.

Der Piezoriegel besteht aus einer Anordnung von abwechselnd gestapelten Piezokeramikschichten und Elektrodenschichten. Der Piezoriegel weist in Stapelrichtung eine Höhe und senkrecht zur Stapelrichtung eine Breite und eine zweite Länge auf. Die zweite Länge ist größer als die erste Länge, vorzugsweise größer als ein Mehrfaches der ersten Länge des zu erhaltenden Piezostacks. Die Elektrodenschichten sind vorzugsweise durchgehend ausgebildet, so dass mit dem Verfahren wenigstens ein vollaktiver Piezostack erhalten wird.

Auf einer ersten Seitenfläche des Piezoriegels mit der zweiten Länge wird erfindungsgemäß eine erste Passivierungsschicht aufgebracht. Die erste Passivierungsschicht ist vorzugsweise dünn. Diese wird anschließend ausgehärtet. Nach dem Aushärten wird der Piezoriegel mechanisch in einen oder mehrere einzelne Piezostacks mit der ersten Länge geteilt, wobei die Randbereiche vorzugsweise verworfen werden,

Bei der Aufbringung der ersten Passivierungsschicht kann aufgrund von Oberflächenspannung eine Kantenflucht zu den Enden des Piezoriegels hin auftreten. Da jedoch vorzugsweise die Enden des Piezoriegels, d.h. die Randbereiche, an welchen die Dicke der Beschichtung aufgrund der Kantenflucht nachlässt, abgetrennt und verworfen werden, wird sichergestellt, dass im Randbereich jedes einzelnen Piezostacks mit der ersten Länge eine vollständige Passivierung, ohne Kantenflucht, vorliegt.

Die Passivierungsschicht des einzelnen Piezostacks mit der ersten Länge bildet somit im Querschnitt senkrecht zur Stapelrichtung ein Rechteck aus und weist eine einheitliche Schichtdicke auf. Die Schichtdicke der Passivierungsschicht ist vorzugsweise über die gesamte Seitenfläche der ersten Länge des einzelnen Piezostacks konstant. Durch die mechanische Teilung des Piezoriegels in einen oder mehrere einzelne Piezostacks der ersten Länge, nachdem die erste Passivierungsschicht aufgetragen wurde, schließt außerdem die ebenfalls durchteilte Passivierungsschicht an den Teilungskanten mit den angrenzenden Seitenflächen der einzelnen Piezostacks bündig ab. Dadurch werden im Betrieb des Piezostacks, also bei anliegender Spannung an den Elektroden, elektrische Überschläge vermieden.

In einer vorteilhaften Ausgestaltung des Verfahrens wird vor der mechanischen Teilung eine zweite Passivierungsschicht auf einer zweiten Seitenfläche des Piezoriegels aufgebracht. Diese zweite Seitenfläche ist auf einer gegenüberliegenden Seite zur wenigstens ersten Seitenfläche angeordnet und weist ebenfalls die zweite Länge auf. Dadurch entsteht ein Piezoriegel mit einer ersten und zweiten Passivierungsschicht, welche auf gegenüberliegenden Seitenflächen angeordnet ist. An diesen beiden Seitenflächen mit den Passivierungsschichten erfolgt auch die spätere elektrische Kontaktierung der einzelnen Piezostacks.

Durch die Herstellung von Piezoriegeln mit zwei gegenüberliegenden Passivierungsschichtungen auf den Elektrodenseiten können einzelne Piezostacks abgetrennt werden, welche direkt kontaktiert werden können. Dies reduziert die Anzahl der Prozessschritte im Vergleich zur Passivierung von vier Seitenflächen. Ferner wird vermieden, dass an den Rändern der beiden Seitenflächen der einzelnen Piezostacks eine verringerte Kantenbenetzung der Passivierung auftritt (Kantenflucht), welche zu einer verminderten elektrischen Isolierung der Elektrode führen kann. Zudem können Schichtdickeninhomogenitäten der Passivierung vermieden werden, welche bei der Passivierung von einzelnen Piezostacks auftreten können, da die Passivierung zur Flächenmitte hin stärker abgeschieden sein kann als an den Rändern.

In einer weiteren vorteilhaften Ausgestaltung des Verfahrens erfolgt die Aufbringung der ersten und/oder zweiten Passivierungsschicht durch Dispensen, Schablonendruck oder Siebdruck. Dies sind gängige Verfahren zur Passivierung von Oberflächen welche effektiv erfolgen und zuverlässige Ergebnisse garantieren.

In einer weiteren vorteilhaften Ausgestaltung des Verfahrens wird die zweite Passivierungsschicht vor der mechanischen Teilung des Piezoriegels ausgehärtet. Die Aushärtung der zweiten Passivierungsschicht am Piezoriegel hat den Vorteil, dass die Aushärtung nur einmal durchgeführt werden muss. Würde die Aushärtung nach der mechanischen Teilung erfolgen, so müsste bei jedem Piezostack einzeln die Aushärtung durchgeführt werden. Auch hier werden Prozessschritte eingespart.

In einer weiteren vorteilhaften Ausgestaltung des erfindungsgemäßen Verfahrens erfolgt die mechanische Teilung des Piezoriegels entlang von Trennachsen, die jeweils senkrecht zu den ersten und zweiten Seitenflächen verlaufen. Dadurch wird erreicht, dass die Flächen des Piezostacks in rechten Winkel zueinander angeordnet sind. Damit wird die Fläche, an welcher der Piezostack abgetrennt wird, parallel zur Hubrichtung im Betrieb ausgerichtet. Dies wiederum ermöglicht, dass sich der Hub des Piezostacks gleichmäßig über die Fläche verteilt.

Gemäß einer weiteren bevorzugten Weiterbildung des erfindungsgemäßen Verfahrens, werden an den durch die Teilung entstandenen Schnittkanten der einzelnen Piezostacks eine dritte und/oder vierte Passivierungsschicht aufgetragen. Diese können beispielsweise durch gängige Verfahren zur Passivierung wie die oben genannten Verfahren aufgetragen werden. Dabei wird die dritte und/oder vierte Passivierungsschicht vorzugsweise nicht nur über die gesamte Breite des einzelnen Piezostacks aufgetragen sondern auch über die Dicke der ersten und/oder zweiten Passivierungsschicht, d.h. über die gesamte bei der Teilung entstandene Schnittkante. Dabei kann die dritte und/oder vierte Passivierungsschicht zu den an die erste und/oder zweite Passivierungsschicht angrenzenden Kanten hin eine abnehmende Schichtdicke (Kantenflucht) aufweisen, ohne dass die Funktionsweise des Piezostacks beeinträchtigt würde.

Weiter Einzelheiten und Vorteile der Erfindung werden in Bezugnahme auf die beigefügten Figuren erläutert.
Darin zeigen schematisch:
Figur 1 einen Piezostack gemäß dem Stand der Technik mit vierseitiger Passivierung;
Figur 2 einen Piezoriegel mit zweiseitiger Passivierung;
Figur 3 einen Piezoriegel mit zweiseitiger Passivierung und Trennachsen;
Figur 4 einen erfindungsgemäßen Piezostack mit zweiseitiger Passivierung;
Figur 5 einen Piezostack mit zweiseitiger Passivierung und elektrischer Kontaktierung; und
Figur 6 einen erfindungsgemäßen Piezostack gemäß einer anderen bevorzugten Ausführungsform mit vierseitiger Passivierung in Schnittansicht.

Bei der nachfolgenden Beschreibung verschiedener bevorzugter Ausführungsformen bezeichnen gleiche Bezugszeichen gleiche oder vergleichbare Komponenten.

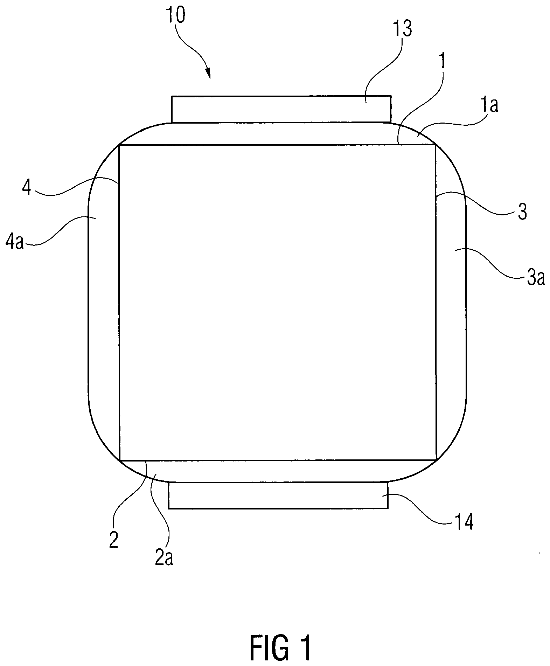

Figur 1 zeigt einen Piezostack 10 gemäß dem Stand der Technik in der Draufsicht mit mehreren Seitenflächen 1, 2, 3, 4; einer ersten 1, zweiten 2, dritten 3 und vierten 4 Seitenfläche, die üblicherweise ein Quadrat oder Rechteck einschließen. Die mehreren Seitenflächen 1, 2, 3, 4 weisen jeweils eine Passivierungsschicht 1a, 2a, 3a, 4a auf, welche Kunststoff umfassen kann. Der Piezostack 10 umfasst ferner elektrische Kontaktierungen 13, 14, welche an zwei gegenüberliegenden Seitenflächen 1, 2 ausgebildet sind. Bei der Passivierung mit Kunststoff wie z.B. Polyimid bzw. Polyimidlack kann es während des Auftrag- und Aushärteprozesses zu Schichtdickeninhomogenitäten kommen, und an den Kanten zu teilweise nicht ausreichender Bedeckung durch die Passivierung. Dies ist in der Figur 1 an den nicht vollständig passivierten Ecken zu sehen. Dies kann im Betrieb zu elektrischen Überschlägen führen, da diese Bereiche nicht ausreichend passiviert und damit isoliert sind.

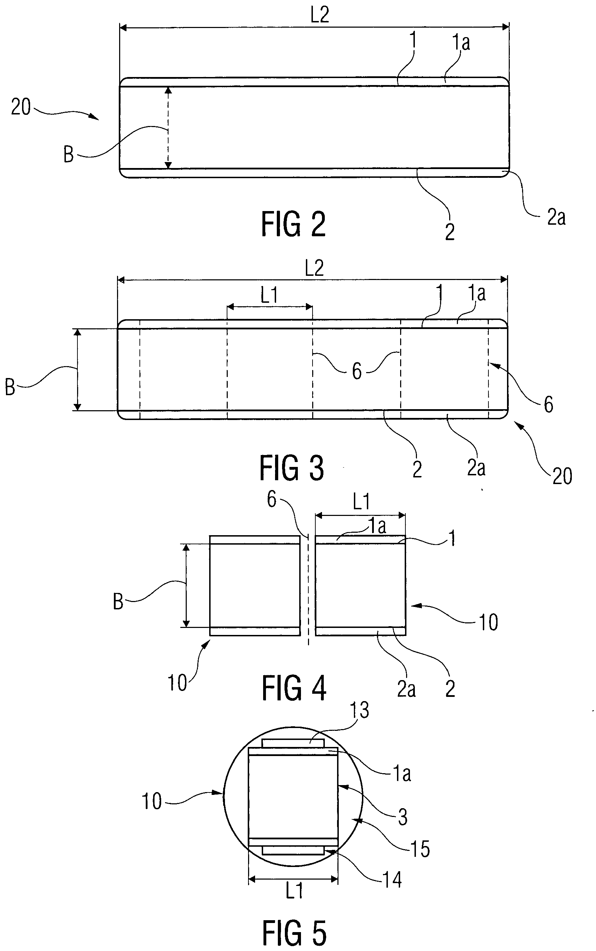

Figur 2 zeigt einen Piezoriegel 20 in der Seitenansicht. Der Piezoriegel 20 weist eine zweite Länge L2 und eine Breite B auf. Der Piezoriegel 20 weist Seitenflächen 1, 2 der Länge L2 auf. In der Figur 2 sind die erste 1 und zweite 2 Seitenfläche in einer Schnittdarstellung gezeigt. An diesen Seitenflächen 1, 2 ist jeweils eine Passivierungsschicht 1a, 2a aufgebracht. Die Passivierungsschicht umfasst beispielsweise Kunststoff. Ein geeigneter Kunststoff ist vorzugsweise temperaturbeständig, weist eine gute Haftung zu Keramik auf und isoliert elektrisch.

Bevorzugt wird als Kunststoff Polyimid oder Polyimidlack eingesetzt.
Im erfindungsgemäßen Verfahren wird zunächst eine erste Passivierungsschicht 1a auf der ersten Seitenfläche 1 des Piezoriegels 20 aufgebracht. Diese erste Passivierungsschicht 1a wird anschließend ausgehärtet. Anschließend wird eine zweite Passivierungsschicht 2a auf einer zweiten Seitenfläche 2 des Piezoriegels aufgebracht, die gegenüberliegend zur ersten Seitenfläche 1 angeordnet ist. Diese zweite Passivierungsschicht 2a wird ebenfalls ausgehärtet. Es ist allerdings auch möglich, dass die erste- und zweite Passivierungsschicht 1a, 2a gleichzeitig aufgebracht werden und im Anschluss gleichzeitig ausgehärtet werden. Dies würde zusätzliche Prozessschritte einsparen.

Weiterhin ist denkbar, dass die erste- und zweite Passivierungsschicht 1a, 2a nacheinander aufgebracht werden aber anschließend gleichzeitig ausgehärtet werden. Auch diese Vorgehensweise würde wenigstens einen Prozessschritt ersparen.

Die Aufbringung von dünnen Schichten, welche zu Passivierungsschichten führt, kann mit gängigen Verfahren wie Dispensen, Schablonendruck oder Siebdruck erfolgen. Die erste und/oder zweite Passivierungsschicht 1a, 2a kann Kunststoff wie Polyimid oder Polyimidlack umfassen. Die erste- und zweite Passivierungsschicht 1a, 2a können auch unterschiedliche Materialien aufweisen.

In Figur 3 ist ein Piezoriegel 20 wie in Figur 2 dargestellt. Zusätzlich sind in Figur 3 Trennachsen 6 markiert, an welchen entlang die mechanische Teilung des Piezoriegels 20 in Piezostacks 10 erfolgt. Die durch die mechanische Teilung entstehenden Piezostacks 10 weisen entsprechend jeweils erste Länge L1 auf. Die Trennachsen 6 verlaufen senkrecht zur zweiten Länge L2. Die durch die Trennung an den Schnittkanten entstehenden Seitenflächen 3, 4 der einzelne Piezostacks 10 weisen jeweils die Breite B auf

In Figur 4 sind zwei Piezostacks (10) dargestellt, durch welche symbolhaft eine Trennachse 6 verläuft. Der Piezostack 10 weist eine erste Seitenfläche 1 mit einer ersten Passivierungsschicht 1a auf. Ferner weist der Piezostack 10 eine zweite Seitenfläche 2 auf, welche gegenüberliegend zur ersten Seitenfläche 1 angeordnet ist. An der zweiten Seitenfläche 2 ist eine zweite Passivierungsschicht 2a aufgebracht. Senkrecht zu der ersten Seitenfläche 1 und der zweiten Seitenfläche 2 ist eine dritte Seitenfläche 3 mit der Breite B dargestellt, auf der beispielsweise Keramik aufgebracht sein kann. Durch die mechanische Teilung des Piezoriegels 20 entlang der Trennachse 6 ist sichergestellt, dass die erste Passivierungsschicht 1a und zweite Passivierungsschicht 2a nur geringe Schichtdickeninhomogenitäten aufweisen, so dass die Passivierungsschichten 1a, 2a im Querschnitt jeweils ein Rechteck ausbilden. Dies betrifft insbesondere den Randbereich, bei dem beim Aufbringen der Passivierungsschicht üblicherweise eine Kantenflucht auftritt, wie in Figur 1 dargestellt. Diese Kantenflucht, bei der die Dicke der Passivierungsschicht 1a, 2a im Randbereich verringert ist, kann so bei den einzelnen Piezostacks vermieden werden, da deren Randbereiche erst nach der Passivierung beziehungsweise nach der mechanischen Teilung entsteht.

In Figur 5 ist ein Piezostack 10 wie in Figur 4 dargestellt. Zusätzlich sind an dem Piezostack 10 eine erste Kontaktierung 13 und eine zweite Kontaktierung 14 dargestellt. Die erste Kontaktierung 13 ist an der ersten Passivierungsschicht 1a angebracht und die zweite elektrische Kontaktierung 14 an der zweiten Passivierungsschicht 2a. Weiterhin ist der Piezostack 10 in einem Verguß 15 eingebettet, welcher die Passivierung der nicht kontaktierten Flächen sicherstellt.
Die Verarbeitung von Piezoriegeln 20 ermöglicht das Aufbringen von Passivierungsschichten über die gesamte Länge L2 des Piezoriegels 20, die auf dem später daraus geteilten Piezostack sehr gleichmäßig auf der Seitenfläche und der Kante des Stacks verlaufen. Desweiteren wird die Zahl der benötigten Prozessschritte (Beschichtung jeder einzelnen Seitenfläche 1, 2, 3, 4) reduziert.

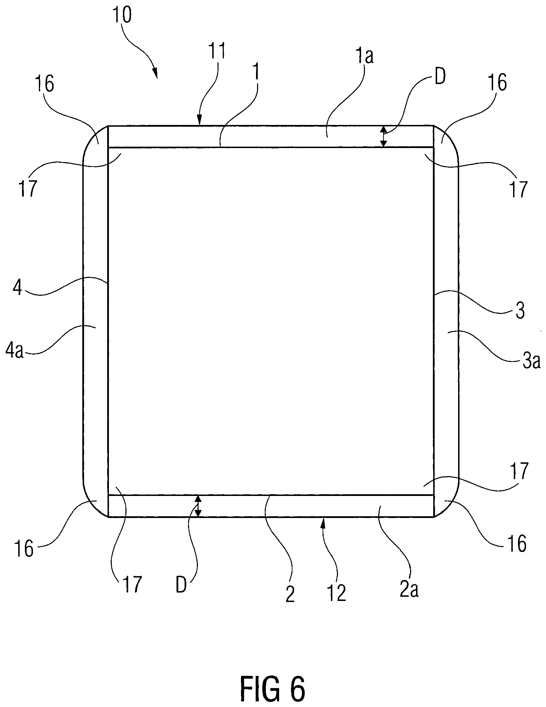

Figur 6 zeigt einen erfindungsgemäßen Piezostack gemäß einer bevorzugten Weiterbildung mit vierseitiger Passivierung in Schnittansicht. Der Piezostack weist vier Seitenflächen 1, 2, 3 und 4 auf. An der ersten Seitenfläche 1 und der gegenüberliegenden Seitenfläche 2 weist der Piezostack eine erste und zweite Passivierungsschicht 1a, 2a mit rechteckigem Querschnitt auf. Die erste und zweite Passivierungsschicht 1a, 2a schließen mit den dritten und vierten Seitenflächen 3, 4 des Piezostacks 10 bündig ab. Die Oberflächen 11 und 12 der ersten und zweiten Passivierungsschicht sind parallel zu den ersten und zweiten Seitenflächen des Piezostacks 1 und 2 ausgebildet. An den dritten und vierten Seitenflächen 3, 4 des Piezostacks 10 ist dieser mit einer dritten und vierten Passivierungssschicht 3a, 4a versehen. Diese erstrecken sich nicht nur über die Breite B der Seitenfläche 3 und 4 des Piezostacks sondern auch über die Dicke der ersten und zweiten Passivierungsschicht 1a, 2a. Zu den Kanten hin weisen die dritte und vierte Passivierungsschicht 3a, 4a eine abnehmende Schichtdicke 16 (Kantenflucht) auf. Dies beeinträchtigt die Funktion des erfindungsgemäßen Piezostacks jedoch nicht, da an den Ecken 17 des Piezostacks eine ausreichende Schichtdicke zur Passivierung vorhanden ist.
Piezostacks 10 mit zweiseitiger Passivierung und das Verfahren zur zweiseitigen Passivierung von Piezoriegeln und die anschließende mechanische Teilung in einzelne Piezostacks können besonders vorteilhaft für Piezostacks für Dieselinjektoren für Kraftfahrzeuge verwendet werden.

## Patentansprüche

1. Verfahren zur Passivierung von wenigstens einer Seitenfläche (1) mit einer ersten Länge (L1) eines Piezostacks (10), wobei die erste Länge (L1) durch mechanische Teilung eines Piezoriegels (20) mit einer zweiten Länge (L2) entlang von zur zweiten Länge (L2) senkrecht verlaufenden Trennachsen (6) entsteht, wobei das Verfahren die folgenden Verfahrensschritte aufweist:
- Bereitstellung eines Piezoriegels (20) mit Seitenflächen (1, 2) mit der zweiten Länge (L2), wobei die zweite Länge (L2) größer ist als die erste Länge (L1),
- Aufbringung einer ersten Passivierungsschicht (1a) auf wenigstens einer ersten Seitenfläche (1) des Piezoriegels (20),
- Aushärtung der ersten Passivierungsschicht (1a),
- anschließend mechanische Teilung des Piezoriegels (20), so dass wenigstens ein Piezostack (10) mit der ersten Länge (L1) erhalten wird.

2. Verfahren nach Anspruch 1, wobei vor der mechanischen Teilung eine zweite Passivierungsschicht (2a) auf einer zweiten Seitenfläche (2) des Piezoriegels (20) aufgebracht wird, welche auf einer gegenüberliegenden Seite zur wenigstens ersten Seitenfläche (1) angeordnet ist.

3. Verfahren nach Anspruch 2, wobei die Aufbringung der ersten und/oder zweiten Passivierungsschicht (1a, 2a) durch Dispensen, Schablonendruck oder Siebdruck erfolgt.

4. Verfahren nach einem der Ansprüche 2 oder 3, wobei die zweite Passivierungsschicht (2a) vor der mechanischen Teilung des Piezoriegels 20 ausgehärtet wird.

5. Verfahren nach einem der Ansprüche 1 bis 4, wobei die mechanische Teilung des Piezoriegels (20) entlang einer oder mehrerer Trennachsen (6) erfolgt, die jeweils senkrecht zu den ersten und zweiten Seitenflächen (1, 2) verlaufen.

6. Verfahren nach einem der Ansprüche 1 bis 5, mit folgenden zusätzlichen Verfahrensschritten:
- Auftragen einer dritten und/oder vierten Passivierungsschicht (3a, 4a) auf eine dritte und/oder vierte Seitenfläche (3, 4) des wenigstens einen Piezostacks (10),
- wobei sich die dritte und/oder vierte Passivierungsschicht (3a, 4a) in ihrer Ausdehnung senkrecht zur Stapelrichtung über die Breite (B) der dritten und/oder vierten Seitenfläche (3, 4) des Piezostacks (10) und die Dicke (D) der ersten und zweiten Passivierungsschicht (1a, 2a) erstreckt.

7. Piezostack (10), hergestellt mit einem Verfahren nach einem der Ansprüche 1 bis 6, umfassend
- mehrere Seitenflächen (1, 2, 3, 4),
- eine erste Passivierungsschicht (1a), welche auf einer ersten Seitenfläche (1) aufgebracht ist,
- wobei die erste Passivierungsschicht (1a) im Querschnitt im Wesentlichen ein Rechteck ausbildet und mit den an die erste Seitenfläche des Piezostacks (1) angrenzenden Seitenflächen des Piezostacks(3, 4) bündig abschließt.

8. Piezostack (10) nach Anspruch 7,
- umfassend eine zweite Passivierungsschicht (2a),
- welche auf einer zweiten Seitenfläche (2) aufgebracht ist,
- wobei die zweite Seitenfläche (2) gegenüberliegend zur ersten Seitenfläche (1) angeordnet ist, und
- wobei die zweite Passivierungsschicht (2a) im Querschnitt im Wesentlichen ein Rechteck ausbildet und mit den an die zweite Seitenfläche des Piezostacks (2) angrenzenden Seitenflächen (3, 4) des Piezostacks bündig abschließt.

9. Piezostack nach einem der Ansprüche 7 oder 8, wobei die erste und/oder zweite Passivierungsschicht (1a, 2a) Kunststoff umfasst.

10. Piezostack nach Anspruch 9, wobei der Kunststoff ein Polyimid umfasst.

11. Piezostack (10) nach einem der Ansprüche 7 bis 10,
- umfassend eine dritte und/oder eine vierte Passivierungsschicht (3a, 4a), welche auf einer dritten und/oder vierten Seitenfläche (3, 4) des Piezostacks (10) aufgebracht ist,
- wobei sich die dritte und/oder vierte Passivierungsschicht (3a, 4a) in ihrer Ausdehnung senkrecht zur Stapelrichtung über die Breite (B) der dritten und/oder vierten Seitenfläche (3, 4) des Piezostacks (10) und die Dicke (D) der ersten und zweiten Passivierungsschicht (1a, 2a) erstreckt.

## Claims

1. Method for the passivation of at least one side surface (1), with a first length (L1), of a piezo stack (10), wherein the first length (L1) arises by mechanical separation of a piezo block (20), with a second length (L2), along separating axes (6) extending perpendicularly to the second length (L2), wherein the method has the following method steps:
- providing a piezo block (20) having side surfaces (1, 2) with the second length (L2), the second length (L2) being greater than the first length (L1),
- applying a first passivation layer (1a) on at least one first side surface (1) of the piezo block (20),
- curing the first passivation layer (1a),
- then mechanically separating the piezo block (20) so that at least one piezo stack (10) with the first length (L1) is obtained.

2. Method according to Claim 1, wherein a second passivation layer (2a) is applied on a second side surface (2) of the piezo block (20), which is arranged on an opposite side to the at least first side surface (1), before the mechanical separation.

3. Method according to Claim 2, wherein the application of the first and/or second passivation layer (1a, 2a) is carried out by dispensing, template printing or screen printing.

4. Method according to one of Claims 2 and 3, wherein the second passivation layer (2a) is cured before the mechanical separation of the piezo block (20).

5. Method according to one of Claims 1 to 4, wherein the mechanical separation of the piezo block (20) is carried out along one or more separating axes (6), which respectively extend perpendicularly to the first and second side surfaces (1, 2).

6. Method according to one of Claims 1 to 5, having the following additional method steps:
- applying a third and/or fourth passivation layer (3a, 4a) onto a third and/or fourth side surface (3, 4) of the at least one piezo stack (10),
- wherein the third and/or fourth passivation layer (3a, 4a) extends in its extent perpendicular to the stack direction beyond the width (B) of the third and/or fourth side surface (3, 4) of the piezo stack (10) and the thickness (D) of the first and second passivation layers (1a, 2a).

7. Piezo stack (10), produced by a method according to one of Claims 1 to 6, comprising
- a plurality of side surfaces (1, 2, 3, 4),
- a first passivation layer (1a), which is applied on a first side surface (1),
- wherein the first passivation layer (1a) essentially forms a rectangle in cross section and ends flush with the side surfaces of the piezo stack (3, 4) which adjoin the first side surface of the piezo stack (1).

8. Piezo stack (10) according to Claim 7,
- comprising a second passivation layer (2a),
- which is applied on a second side surface (2),
- wherein the second side surface (2) is arranged opposite the first side surface (1), and
- wherein the second passivation layer (2a) essentially forms a rectangle in cross section and ends flush with the side surfaces of the piezo stack (3, 4) which adjoin the second side surface of the piezo stack (2).

9. Piezo stack (10) according to one of Claims 7 and 8, wherein the first and/or second passivation layer (1a, 2a) comprises plastic.

10. Piezo stack (10) according to Claim 9, wherein the plastic comprises a polyimide.

11. Piezo stack (10) according to one of Claims 7 to 10,
- comprising a third and/or a fourth passivation layer (3a, 4a), which is applied on a third and/or fourth side surface (3, 4) of the piezo stack (10),
- wherein the third and/or fourth passivation layer (3a, 4a) extends in its extent perpendicular to the stack direction beyond the width (B) of the third and/or fourth side surface (3, 4) of the piezo stack (10) and the thickness (D) of the first and second passivation layers (1a, 2a).

## Revendications

1. Procédé destiné à la passivation de tout au moins une surface latérale (1) avec une première longueur (L1) d'une pile piézoélectrique (10) ; dans lequel la première longueur (L1) est obtenue par la division mécanique d'un pêne de verrouillage piézoélectrique (20) avec une deuxième longueur (L2), le long des axes de séparation (6) qui courent à la perpendiculaire de la deuxième longueur (L2) ; dans lequel le procédé présente les phases de procédé suivantes :
- la mise à disposition d'un pêne de verrouillage piézoélectrique (20), comprenant des surfaces latérales (1, 2), avec la deuxième longueur (L2) ; dans lequel la deuxième longueur (L2) est plus grande que la première longueur (L1) ;
- la mise en place d'une première couche de passivation (la) sur tout au moins une première surface latérale (1) du pêne de verrouillage piézoélectrique (20) ;
- le durcissement de la première couche de passivation (la) ;
- puis, la division mécanique du pêne de verrouillage piézoélectrique (20), de telle sorte que tout au moins une pile piézoélectrique (10) est obtenue au moyen de la première longueur (L1).

2. Procédé selon la revendication 1, dans lequel une deuxième couche de passivation (2a) est appliquée sur une deuxième surface latérale (2) du pêne de verrouillage piézoélectrique (20) avant la division mécanique, laquelle surface latérale est disposée sur une face qui se trouve à l'opposé par rapport à la tout au moins première surface latérale (1).

3. Procédé selon la revendication 2, dans lequel la mise en place de la première couche de passivation et/ou de la deuxième couche de passivation (1a, 2a) est réalisée au moyen d'une méthode au distributeur, par impression au pochoir ou par sérigraphie.

4. Procédé selon l'une des revendications 2 ou 3, dans lequel la deuxième couche de passivation (2a) est durcie avant la division mécanique du pêne de verrouillage piézoélectrique (20).

5. Procédé selon l'une des revendications 1 à 4, dans lequel la division mécanique du pêne de verrouillage piézoélectrique (20) est réalisée le long d'un ou de plusieurs axes de séparation (6), lesquels courent respectivement à la perpendiculaire des premières surfaces latérales et des deuxièmes surfaces latérales (1, 2).

6. Procédé selon l'une des revendications 1 à 5, comprenant les phases de procédé suivantes supplémentaires :
- la mise en place d'une troisième couche de passivation et/ou d'une quatrième couche de passivation (3a, 4a) sur une troisième surface latérale et/ou sur une quatrième surface latérale (3, 4) de la tout au moins une pile piézoélectrique (10) ;
- dans lequel la troisième couche de passivation et/ou la quatrième couche de passivation (3a, 4a) s'étendent, dans leur extension, à la perpendiculaire de la direction de l'empilement, sur la largeur (B) de la troisième surface latérale et/ou de la quatrième surface latérale (3, 4) de la pile piézoélectrique (10), ainsi que sur l'épaisseur (D) de la première couche de passivation et de la deuxième couche de passivation (1a, 2a).

7. Pile piézoélectrique (10), fabriquée au moyen d'un procédé selon l'une des revendications 1 à 6, comprenant :
- plusieurs surfaces latérales (1, 2, 3, 4) ;
- une première couche de passivation (1a), laquelle est appliquée sur une première surface latérale (1) ;
- dans laquelle la première couche de passivation (1a) forme pour l'essentiel un rectangle dans la section transversale et se termine en affleurement au niveau des surfaces latérales de la pile piézoélectrique (3, 4) qui sont contiguës à la première surface latérale de la pile piézoélectrique (1).

8. Pile piézoélectrique (10) selon la revendication 7,
- comprenant une deuxième couche de passivation (2a),
- laquelle est appliquée sur une deuxième surface latérale (2) ;
- dans laquelle la deuxième surface latérale (2) est disposée à l'opposé de la première surface latérale (1) ; et
- dans laquelle la deuxième couche de passivation (2a) forme pour l'essentiel un rectangle dans la section transversale et se termine en affleurement au niveau des surfaces latérales (3, 4) de la pile piézoélectrique qui sont contiguës à la deuxième surface latérale (2) de la pile piézoélectrique.

9. Pile piézoélectrique selon l'une des revendications 7 ou 8, dans laquelle la première couche de passivation et/ou la deuxième couche de passivation (1a, 2a) comprennent une matière plastique.

10. Pile piézoélectrique selon la revendication 9, dans laquelle la matière plastique comprend un polyimide.

11. Pile piézoélectrique (10) selon l'une des revendications 7 à 10,
- comprenant une troisième couche de passivation et/ou une quatrième couche de passivation (3a, 4a), laquelle est appliquée sur une troisième surface latérale et/ou sur une quatrième surface latérale (3, 4) de la pile piézoélectrique (10) ;
- dans laquelle la troisième couche de passivation et/ou la quatrième couche de passivation (3a, 4a) s'étendent, dans leur extension, à la perpendiculaire de la direction de l'empilement, sur la largeur (B) de la troisième surface latérale et/ou de la quatrième surface latérale (3, 4) de la pile piézoélectrique (10), ainsi que sur l'épaisseur (D) de la première couche de passivation et de la deuxième couche de passivation (1a, 2a).
